(19) Europäisches Patentamt

European Patent Office

Office européen des brevets

(11) **EP 1 646 142 A1**

(12) **EUROPEAN PATENT APPLICATION**

(43) Date of publication:
**12.04.2006 Bulletin 2006/15**

(51) Int Cl.:
*H03C 3/40* $^{(2006.01)}$

(21) Application number: **04023958.4**

(22) Date of filing: **07.10.2004**

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(71) Applicant: **Infineon Technologies AG**
**81669 München (DE)**

(72) Inventor: **Rudberg, Mikael**
**583 32 Linköping (SE)**

(74) Representative: **Graf Lambsdorff, Matthias**
**Patentanwälte**
**Lambsdorff & Lange**
**Dingolfinger Strasse 6**
**81673 München (DE)**

(54) **Digital frequency conversion using Taylor approximation**

(57)   The present invention relates to a system (10) for digital frequency conversion, intended for use in a radio system. The system (10) comprises a frequency synthesis means (30) connected to a table look-up means, both operable to give approximation of a sinusoid. The system (10) also comprises a Taylor expansion means (16) connected to said table look-up means, which is operable to perform a vector rotation, thereby improving the accuracy of the sinusoid.

FIG 3

EP 1 646 142 A1

## Description

Field of the invention

The present invention relates in a first aspect to a system for digital frequency conversion, intended for use in a radio system.

In a second aspect the present invention relates to a method for digital frequency conversion, intended for use in a radio system.

In a third aspect the present invention relates to at least one computer program product for digital frequency conversion, intended for use in a radio system.

Background of the invention

In modern radio architecture some of the frequency conversion to/from baseband rates are made in the digital domain. To keep a high flexibility in the frequency planning the generation of high quality sinusoids with arbitrary frequencies is essential. For instance the third generation mobile systems require a frequency accuracy in the range of kHz.

There are numerous methods available for digital frequency synthesis. Here is a short summary of the most common ones.

By storing one period of a sine-wave in a memory and then use a counter as pointer to the table is the most commonly used method in existing products. The basic method is very simple and can be boosted by various techniques like dithering and a second addition step.

This method is very attractive when combined with dithering and/or a second addition step. However, in order to reach an acceptable performance for the requirements put by a radio basestation for the 3rd generation mobile systems the size of the memory table will be very large making this solution quite expensive in terms of hardware cost.

Some methods are based in an iteration using some iteration formula for sin () and cos () calculation (e.g. the Cordic algorithm). However, you can rarely see this method implemented in real products due to the high hardware cost to reach high resolution. There are also methods combining the two basic methods with table look-up and iterations.

Summary of the invention

The above mentioned problem are solved with a system for digital frequency conversion, intended for use in a radio system according to Claim 1. The system comprises a frequency synthesis means connected to a table look-up means, both operable to give an approximation of a sinusoid. The system also comprises a to said table look-up means connected Taylor expansion means operable to perform a vector rotation, thereby improving the accuracy of said sinusoid.

An advantage with this system is that it is possible to reach a high resolution without the disadvantage with high hardware cost.

A further advantage in this context is obtained if said frequency synthesis means comprises a counter means with a programmable step size (S).

In this context, a further advantage is obtained if said counter means is increased with the value S for every update.

A further advantage in this context is obtained if said table look-up means has M entries, wherein the number of bits used for the table look-up will be m= log2 (M).

In this context, a further advantage is obtained if the m most significant bits from said counter means are used as an address to said table look-up means, i.e. the address is m_msb (counter_value), and in that the resolution of said counter means is k bits, and in that k > m.

A further advantage in this context is obtained if the synthesized frequency is

$$f = \frac{fclk}{M} \cdot S$$

wherein fclk is the used clock frequency.

In this context, a further advantage is obtained if said system also comprises an adding means connected to said counter means and said table look-up means, wherein said adding means receives an input signal from said counter means, and an input signal (PHOFFSET), and outputs the address to said table look-up means, whereby said input signal (PHOFFSET) is used to adjust the phase of said sinusoid.

A further advantage in this context is obtained if said table look-up means stores the values

$$\cos\left(2\pi\frac{n}{M}\right), \text{ and } \sin\left(2\pi\frac{n}{M}\right)$$

wherein n=0,...,*M*-1.

In this context, a further advantage is obtained if said table look-up means stores the values

$$\sin\left(2\pi\frac{n}{M}\right)$$

wherein

$$\text{n} = 0, ..., \frac{M-1}{4} \quad .$$

A further advantage in this context is obtained if said Taylor expansion means comprises a number of multiplication means, and a number of adding means.

In this context, a further advantage is obtained if said vector rotation can be described as:

$$\begin{bmatrix} s'_I \\ s'_Q \end{bmatrix} = \begin{bmatrix} s_I & s_Q \end{bmatrix} \cdot \begin{bmatrix} \cos(\varphi_i)\sin(\varphi_i) \\ -\sin(\varphi_i)\cos(\varphi_i) \end{bmatrix}$$

whereby $\varphi_i$ is determined by:

$$\varphi_i = \frac{2\pi \cdot m\_msb(counter\_val)}{M}$$

A further advantage in this context is obtained if said Taylor expansion means performs an additional vector rotation, which can be described as:

$$\begin{bmatrix} s'_I \\ s'_Q \end{bmatrix} = \begin{bmatrix} s_I & s_Q \end{bmatrix} \cdot \begin{bmatrix} \cos(\varphi_i) & \sin(\varphi_i) \\ -\sin(\varphi_i)\cos(\varphi_i) \end{bmatrix} \cdot \begin{bmatrix} \cos(\Delta\varphi_i) & \sin(\Delta\varphi_i) \\ -\sin(\Delta\varphi_i)\cos(\Delta\varphi_i) \end{bmatrix}$$

wherein $\Delta\varphi$ is an angle error due to the fact that not all bits in said counter means are used for said table look-up.

In this context, a further advantage is obtained, if assuming that $\Delta\varphi_i$ is small, the sin ( ), and cos ( ) operations can be approximated with

$$\sin(\Delta\varphi_i) \approx \Delta\varphi_i$$

$$\cos(\Delta\varphi_i) \approx 1$$

whereby said Taylor expansion means performs said additional vector rotation, which can be described as:

$$\begin{bmatrix} s'_I \\ s'_Q \end{bmatrix} = \begin{bmatrix} s_I & s_Q \end{bmatrix} \cdot \begin{bmatrix} \cos(\varphi_i)\sin(\varphi_i) \\ -\sin(\varphi_i)\cos(\varphi_i) \end{bmatrix} \cdot \begin{bmatrix} 1 & \Delta\varphi_i \\ -\Delta\varphi_i & 1 \end{bmatrix} = S \cdot A \cdot B$$

The above mentioned problems are also solved with a method for digital frequency conversion, intended for use in a radio system according to Claim 14. The method comprises the steps:

- to perform a frequency synthesis; and
- to perform a table look-up resulting in an approxima tion of a sinusoid; and
- to perform a Taylor expansion in the form of a vector rotation, thereby improving the accuracy of said sinusoid.

An advantage with this method is that it is possible to reach a high resolution without the disadvantage of increased complexity.

A further advantage in this context is obtained if said table look-up step comprises the steps:

- to generate an address for said table look-up, using the m most significant bits from a counter means, i.e. the address is m_msb (counter_value)
- to increase said counter_value with a step size S; and
- to repeat the above mentioned steps.

In this context, a further advantage is obtained if said table comprises M words, and in that the number of bits use for said table look-up will be m = log2(M).

A further advantage in this context is obtained if the synthesized frequency is

$$f = \frac{fclk}{M} \cdot S \quad ,$$

wherein fclk is the used clock frequency.

In this context, a further advantage is obtained if said method also comprises the step:

- to add a signal (PHOFFSET) to adjust the phase of said sinusoid.

A further advantage in this context is obtained if said table stores the values

$$\cos\left(2\pi\frac{n}{M}\right), \text{ and } \sin\left(2\pi\frac{n}{M}\right),$$

wherein $n$=0,...,$M$-1.

In this context, a further advantage is obtained if said table stores the values

$$\sin\left(2\pi\frac{n}{M}\right) ,$$

wherein

$$n = 0, \ldots, \frac{M-1}{4}.$$

A further advantage in this context is obtained if said vector rotation can be described as:

$$\begin{bmatrix} s'_I \\ s'_Q \end{bmatrix} = \begin{bmatrix} s_I & s_Q \end{bmatrix} \cdot \begin{bmatrix} \cos(\varphi_i) & \sin(\varphi_i) \\ -\sin(\varphi_i) & \cos(\varphi_i) \end{bmatrix}$$

whereby $\varphi_i$ is determined by:

$$\varphi_i = \frac{2\pi \cdot m\_msb(counter\_val)}{M}$$

In this context, a further advantage is obtained if said method also comprises the step:

- to perform an additional vector rotation, which can be described as:

$$\begin{bmatrix} s'_I \\ s'_Q \end{bmatrix} = \begin{bmatrix} s_I & s_Q \end{bmatrix} \cdot \begin{bmatrix} \cos(\varphi_i) & \sin(\varphi_i) \\ -\sin(\varphi_i) & \cos(\varphi_i) \end{bmatrix} \cdot \begin{bmatrix} \cos(\Delta\varphi_i) & \sin(\Delta\varphi_i) \\ -\sin(\Delta\varphi_i) & \cos(\Delta\varphi_i) \end{bmatrix}$$

wherein $\Delta\varphi$ is an angle error due to the fact that not all bits in said counter means are used for said table look-up.
A further advantage in this context is obtained if assuming that $\Delta\varphi_i$ is small, the sin ( ), and cos ( ) operations can be approximated with

$$\sin(\Delta\varphi_i) \approx \Delta\varphi_i$$

$$\cos(\Delta\varphi_i) \approx 1,$$

whereby said additional vector rotation can be described as:

$$\begin{bmatrix} s'_I \\ s'_Q \end{bmatrix} = \begin{bmatrix} s_I & s_Q \end{bmatrix} \cdot \begin{bmatrix} \cos(\varphi_i) & \sin(\varphi_i) \\ -\sin(\varphi_i) & \cos(\varphi_i) \end{bmatrix} \cdot \begin{bmatrix} 1 & \Delta\varphi_i \\ -\Delta\varphi_i & 1 \end{bmatrix} = S \cdot A \cdot B$$

The above mentioned problems are also solved with at least one computer program product, intended for use in a radio system according to Claim 24. The at least one computer program product is/are directly loadable into the internal memory of at least one digital computer. The at least one computer program product comprises software code portions for performing the steps of Claim 14 when said said at least one product is/are run on said at least one computer,
**[0035]** An advantage with this/these product/products is/are that it is possible to reach a high resolution without the disadvantage of increased complexity.

The embodiments of the invention will now be described with reference to the attached drawings, where:

Brief description of the Drawings

Fig. 1 is a block diagram of a radio architecture utilizing digital frequency conversing according to the prior art;

Fig. 2 is a block diagram of a system for digital frequency conversion according to the present invention;

Fig. 3 is a more detailed block diagram of the system disclosed in fig. 2;

Fig. 4 is a block diagram of the frequency synthesis part of the system disclosed in fig. 3;

Fig. 5 is a block diagram of the post processing part of the system disclosed in fig. 3;

Fig. 6 is a flow chart of a method for digital frequency conversion according to the present invention;

Fig. 7 is a more detailed flow chart of the method according to the present invention; and

Fig. 8 shows a schematic diagram of some computer program products according to the present invention.

Detailed description of embodiments

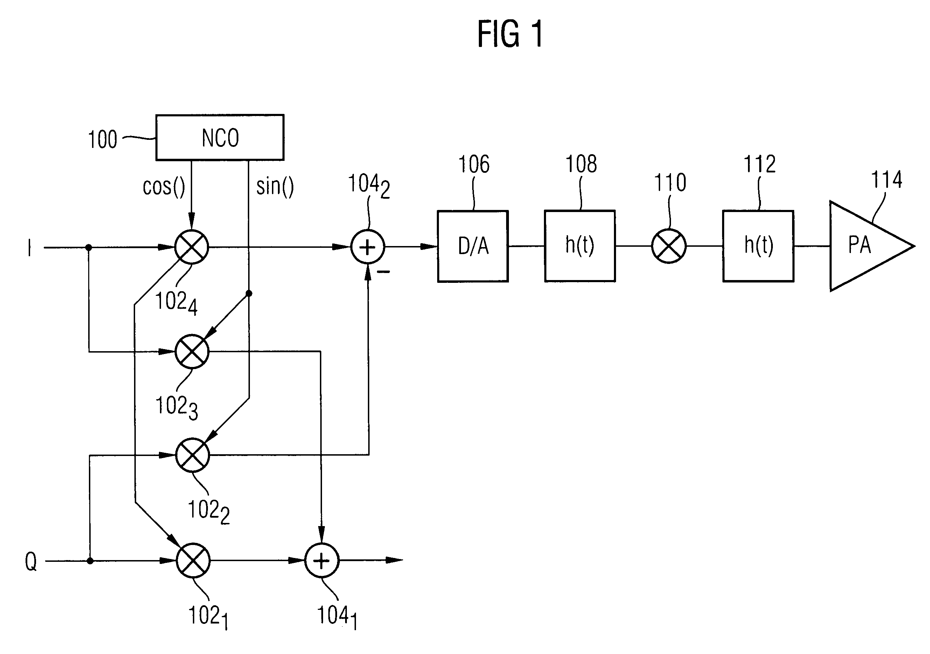

In fig. 1 there is disclosed a block diagram of a radio architecture utilizing digital frequency conversion according to the prior art. As is apparent in fig. 1, the architecture comprises a numerically controlled oscillator 100 operable to provide cos ()- and sin () -signals. The architecture also comprises four multiplication means $102_1$, $102_2$, $102_3$, $102_4$, some of which are connected to said numerically controlled oscillator 100. The four multiplication means $102_1$ - $102_4$ are also provided with an input signal, in the form of I- or Q-signals. The architecture also comprises two adding means $104_1$, $104_2$ connected to said four multiplication means $102_1$ - $102_4$. The architecture also comprises a D/A-converter 106 operable to perform a digital/analogue conversion. A first filter means 108 is connected to said D/A-converter 106. The architecture also comprises a further multiplication means 110 connected to said first filter means 108. Finally, said architecture comprises a second filter means 112 connected to said multiplication means 110, and a to said second filter means 112 connected power amplifier 114. The I- and Q-signals are phase shifted 90° in relation to each other.

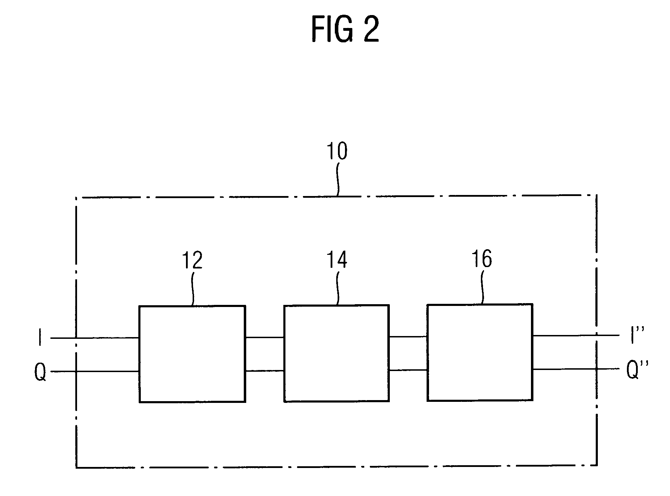

In Fig. 2 there is disclosed a block diagram of a system 10 for digital frequency conversion, intended for use in a radio system according to the present invention. The system 10 comprises a frequency synthesis means 12 which receives the I-and Q-signals as input signals. The system 10 also comprises a to said frequency synthesis means 12 connected table look-up means 14. The frequency synthesis means 12 and the table look-up means 14 are booth operable to give an approximation of a sinusoid. The system 10 also comprises a Taylor expansion means 16 connected to said table look-up means 14. The Taylor expansion means 16 is operable to perform a vector rotation, thereby improving the accuracy of said sinusoid.

The vector rotation can be described as:

$$\begin{bmatrix} s'_I \\ s'_Q \end{bmatrix} = \begin{bmatrix} s_I & s_Q \end{bmatrix} \cdot \begin{bmatrix} \cos(\varphi_i) & \sin(\varphi_i) \\ -\sin(\varphi_i) & \cos(\varphi_i) \end{bmatrix} \cdot \begin{bmatrix} \cos(\Delta\varphi_i) & \sin(\Delta\varphi_i) \\ -\sin(\Delta\varphi_i) & \cos(\Delta\varphi_i) \end{bmatrix}$$

The radio system can e.g. be a WLAN system, a GSM system, an UMTS system or a CDMA 2000 system.

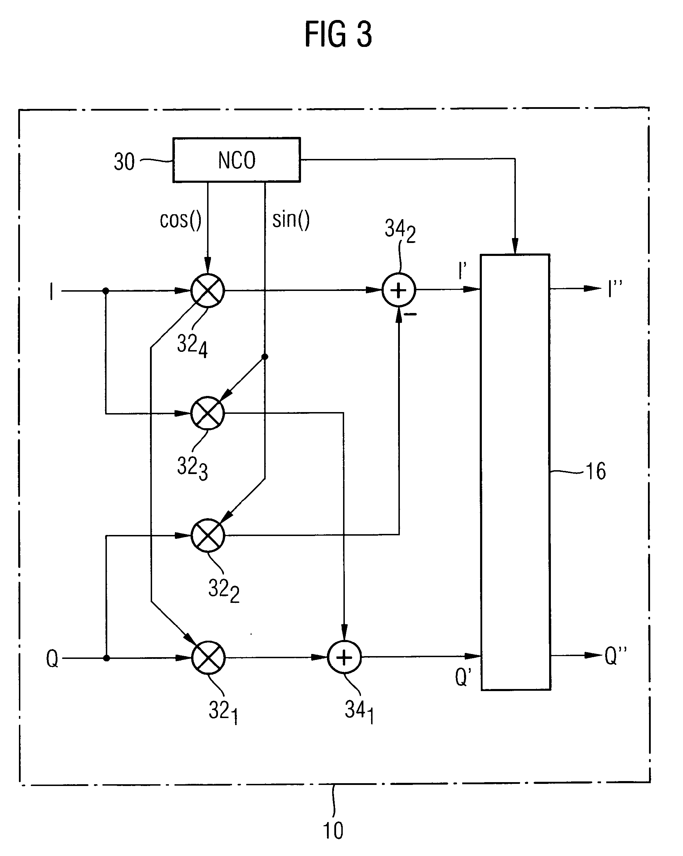

In Fig. 3 there is disclosed a more detailed block diagram of the system 10 disclosed in fig. 2. In fig. 3 said frequency synthesis means 12 and said table look-up means 14 are illustrated in the form of a numerically control oscillator 30 connected to four multiplication means $32_1$, $32_2$, $32_3$, $32_4$, and two adding means $34_1$, $34_2$ connected to said four multiplication means $32_1$ - $32_4$. The two adding means $34_1$, $34_2$ and said numerically controlled oscillator 30 are connected to said Taylor expansion means 16, which outputs the signals I″ and Q″.

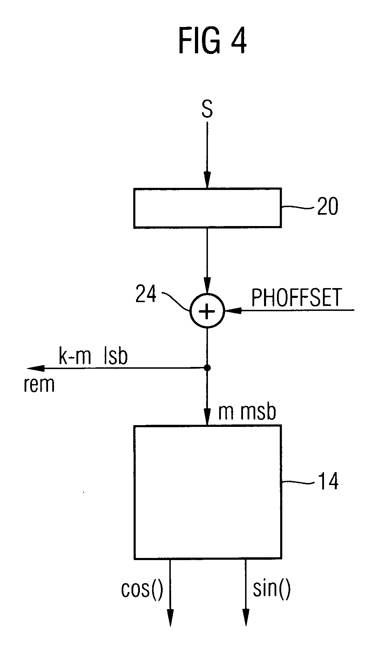

In Fig. 4 there is disclosed a block diagram of the frequency synthesis part of the system 10 disclosed in fig. 3. The frequency synthesis part comprises a counter means 20 with a programmable step size S. This means that said counter means 20 is increased with the value S for every update. As is apparent in fig. 4, an adding means 24 is connected to said counter means 20, which adding means 24 also is connected to said table look-up means 14. The adding means 24 receives an input signal from said counter means 20, and an input signal (PHOFFSET) which can be used to adjust the phase of the sinusoid from the table look-up means 14. As is apparent in fig. 4, the m most significant bits from the counter means 20 are used as an address to the table look-up means 14, i.e. the address is m _msb (counter_value). The resolution of the counter means 20 is k bits, and k>m.

According to one preferred embodiment of said system 10, the table look-up means 14 has M entries, wherein the number of bits used for the table look-up will be m = log 2(M):

The synthesized frequency is

$$f = \frac{fclk}{M} \cdot S$$

wherein $f_{clk}$ is the used clock frequency.

According to one preferred embodiment of said system 10, the table look-up means 14 stores the values

$$\cos\left(2\pi \frac{n}{M}\right), \text{ and } \sin\left(2\pi \frac{n}{M}\right)$$

wherein n=0,...,*M*-1.

According to another preferred embodiment of said system 10, the table look-up means 14 stores the values

$$\sin\left(2\pi \frac{n}{M}\right) \quad ,$$

wherein

$$n = 0, ..., \frac{M-1}{4} \quad .$$

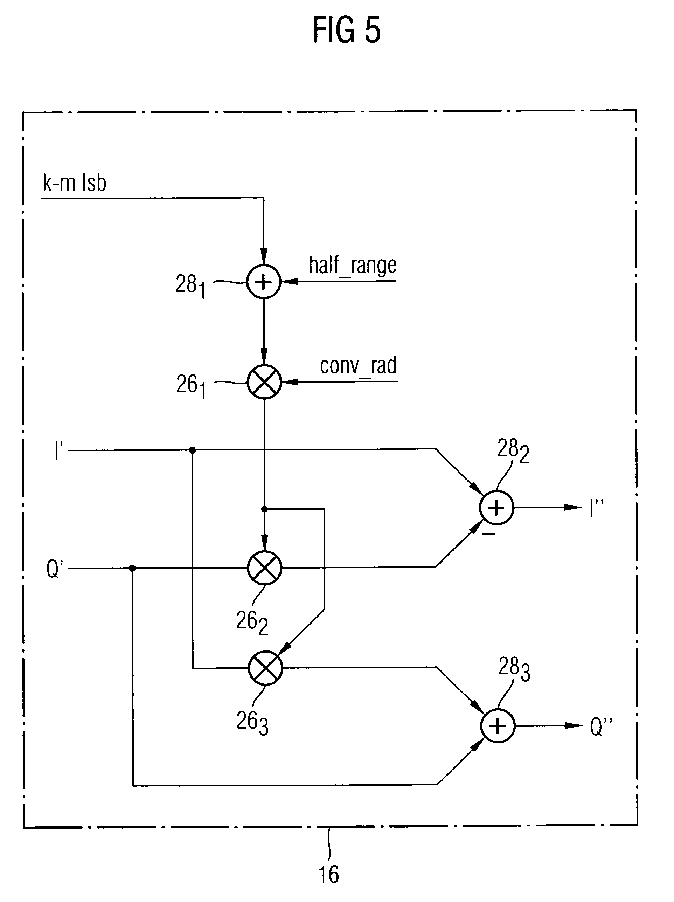

In Fig. 5, there is disclosed a block diagram of the post processing part of the system 10 disclosed in fig. 3. The Taylor expansion means 16 comprises a number of multiplication means $26_1,...,26_t$, wherein t is an integer. In fig. 5 t is 3. The Taylor expansion means 16 also comprises a number of adding means $28_1,..., 28_P$, wherein p is an integer. In fig. 5, p is 3. The addition with "the half range" (the adding means $28_1$) represents a translation from an angle error in the range [0, $2^{k-m}$ - 1] to the range [-2 $^{k-m-1}$, $2^{k-m}$- 1]. Note that this conversion also can be made by inverting the most significant bit and interpret the result as a signed value in 2's complement representation. The multiplication with "conv-_ rad" (the multiplication means $26_1$) is a conversion from the range [-$2^{k-m-1}$, $2^{k-m}$-1], to the corresponding radians. That is, conv_rad = (2 $\pi$)/M. The vector rotation performed by said Taylor expansion means 16 can be described as:

$$\begin{bmatrix} s'_I \\ s'_Q \end{bmatrix} = \begin{bmatrix} s_I & s_Q \end{bmatrix} \cdot \begin{bmatrix} \cos(\varphi_i) & \sin(\varphi_i) \\ -\sin(\varphi_i) & \cos(\varphi_i) \end{bmatrix} \cdot \begin{bmatrix} \cos(\Delta\varphi_i) & \sin(\Delta\varphi_i) \\ -\sin(\Delta\varphi_i) & \cos(\Delta\varphi_i) \end{bmatrix}$$

Here in below follows an explanation of the background to the vector rotation.

The frequency conversion that we want to perform is in fact a vector rotation that can be described as:

$$
\begin{bmatrix} s'_I \\ s'_Q \end{bmatrix} = \begin{bmatrix} s_I & s_Q \end{bmatrix} \cdot \begin{bmatrix} \cos(\varphi_i)\sin(\varphi_i) \\ -\sin(\varphi_i)\cos(\varphi_i) \end{bmatrix}
$$

where $\varphi_i$ i is determined by:

$$
\varphi_i = \frac{2\pi \cdot m\_msb(counter\_val)}{M}
$$

Since not all bits in the counter means 20 is used for the table look up the resulting values do not represent the actual angle, but instead the closest angle that happens to be stored in the table look-up means 14.

This angle error $\Delta\varphi$ is proportional to the (k-m)lsb bits in the counter state that not is used for the table look-up. This angle error $\Delta\varphi$ can be corrected if we make an additional rotation operation as described below:

$$
\begin{bmatrix} s'_I \\ s'_Q \end{bmatrix} = \begin{bmatrix} s_I & s_Q \end{bmatrix} \cdot \begin{bmatrix} \cos(\varphi_i) & \sin(\varphi_i) \\ -\sin(\varphi_i) & \cos(\varphi_i) \end{bmatrix} \cdot \begin{bmatrix} \cos(\Delta\varphi_i) & \sin(\Delta\varphi_i) \\ -\sin(\Delta\varphi_i) & \cos(\Delta\varphi_i) \end{bmatrix}
$$

Assuming that $\Delta\varphi$; is small we can approximate the sin () and cos () operations with

$$
\sin(\Delta\varphi_i) \approx \Delta\varphi_i
$$

$$
\cos(\Delta\varphi_i) \approx 1
$$

This yields the following more simple second rotation operation:

$$
\begin{bmatrix} s'_I \\ s'_Q \end{bmatrix} = \begin{bmatrix} s_I & s_Q \end{bmatrix} \cdot \begin{bmatrix} \cos(\varphi_i) & \sin(\varphi_i) \\ -\sin(\varphi_i) & \cos(\varphi_i) \end{bmatrix} \cdot \begin{bmatrix} 1 & \Delta\varphi_i \\ -\Delta\varphi_i & 1 \end{bmatrix} = S \cdot A \cdot B
$$

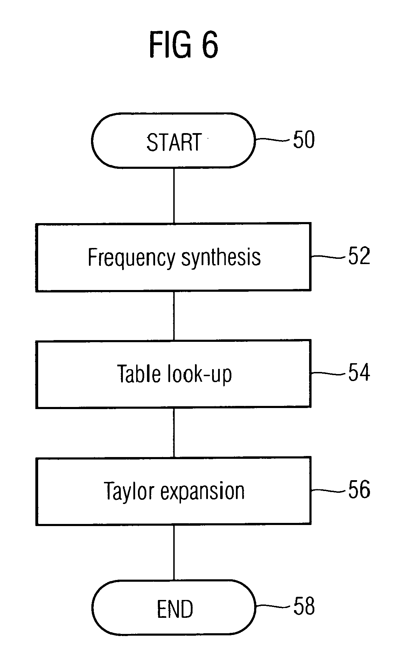

In fig. 6 there is disclosed a flow chart of a method for digital frequency conversion, intended for use in a radio system according to the present invention. The method begins at block 50. The method continues, at block 52, with the step: to perform a frequency synthesis. Thereafter, the method continues, at block 54 with the step: to perform a table look-up, resulting in an approximation of a sinusoid. The method continues, at block 56, with the step: to perform a Taylor expansion in the form of a vector rotation, thereby improving the accuracy of said sinusoid.

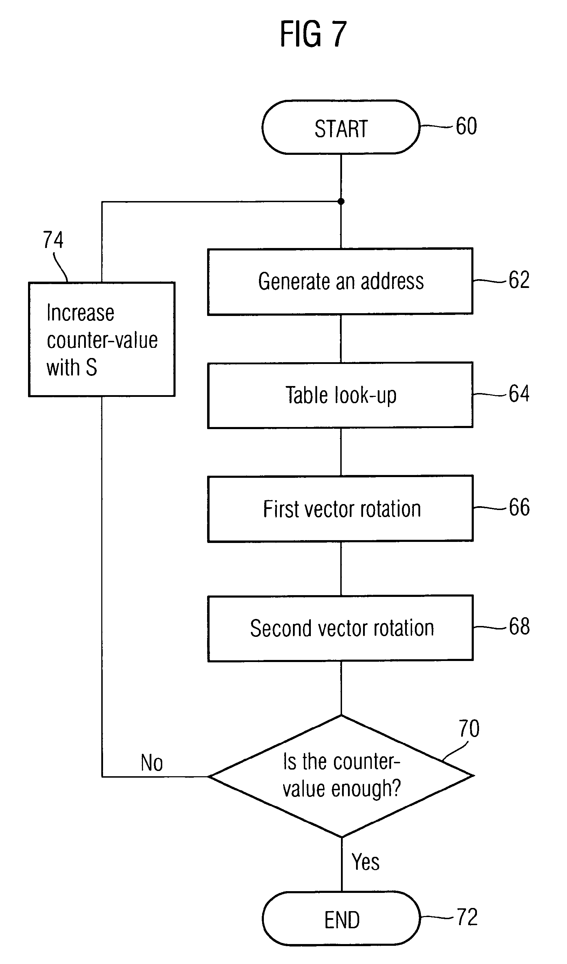

In Fig. 7 there is disclosed a more detailed flow chart of the method according to the present invention. The method begins at block 60. The method continues, at block 62, with the step: to generate an address for said table look-up, using the m most significant bits from the counter means 20 (see fig. 3), i.e. the address is m_msb (counter_ value). Thereafter, the method continues at block 64, with the step: to perform said table look-up with said address, giving the values

$$\cos(2\pi \frac{n}{M}), \text{and} \sin(2\pi \frac{n}{M})$$

wherein n = 0,...,M -1. The method continues, at block 66, with the step: to perform a first vector rotation, which can be described as:

$$\begin{bmatrix} s'_I \\ s'_Q \end{bmatrix} = [s_I \ s_Q] \cdot \begin{bmatrix} \cos(\varphi_i) & \sin(\varphi_i) \\ -\sin(\varphi_i) & \cos(\varphi_i) \end{bmatrix}$$

whereby $\varphi_i$ is determined by:

$$\varphi_i = \frac{2\pi \cdot m\_msb(counter\_val)}{M}$$

Thereafter, the method continues, at block 68, with the step: to perform a second, additional, vector rotation, which can be described as:

$$\begin{bmatrix} s'_I \\ s'_Q \end{bmatrix} = [s_I \ s_Q] \cdot \begin{bmatrix} \cos(\varphi_i) & \sin(\varphi_i) \\ -\sin(\varphi_i) & \cos(\varphi_i) \end{bmatrix} \cdot \begin{bmatrix} \cos(\Delta\varphi_i) & \sin(\Delta\varphi_i) \\ -\sin(\Delta\varphi_i) & \cos(\Delta\varphi_i) \end{bmatrix}$$

wherein $\Delta\varphi$ is an angle error due to the fact that not all bits in said counter'means are used for said table look-up. The method continues, at block 70, with the step: to ask the question: Is the counter_value enough? If the answer is affirmative the method is completed, at block 72. If the answer, on the other hand, is no, the method continues, at block 74, with the step: to increase the counter_value with the step size S. Thereafter the method step according to block 62 is performed again.

If we assume that $\Delta\varphi_i$ is small, the sin (), and cos () operations can be approximated with

$$\sin(\Delta\varphi_i) \approx \Delta\varphi_i$$

$$\cos(\Delta\varphi_i) \approx 1,$$

whereby said second, additional vector rotation can be described as:

$$\begin{bmatrix} s'_I \\ s'_Q \end{bmatrix} = [s_I \ s_Q] \cdot \begin{bmatrix} \cos(\varphi_i) & \sin(\varphi_i) \\ -\sin(\varphi_i) & \cos(\varphi_i) \end{bmatrix} \cdot \begin{bmatrix} 1 & \Delta\varphi_i \\ -\Delta\varphi_i & 1 \end{bmatrix} = S \cdot A \cdot B$$

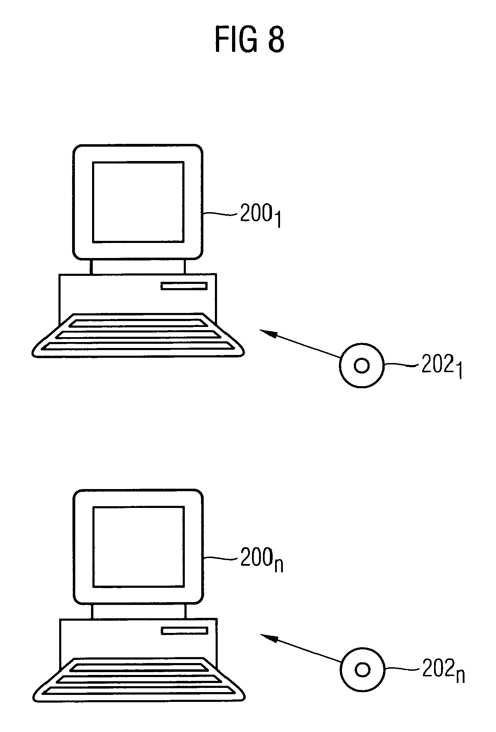

In Fig. 8 there is disclosed a schematic diagram of some computer program products, intended for use in a radio system according to the present invention. There is disclosed n different digital computers $200_1$, ..., $200_n$, wherein n is an integer. There is also disclosed n different computer program products $202_1$, ..., $202_n$, here showed in the form of compact discs. The different computer program products $202_1$, ..., $202_n$ are directly loadable into the internal memory of the n different digital computers $100_1$, ..., $100_n$. Each computer program product $202_1$, ..., $202_n$ comprises software

code portions for performing some or all the steps of Fig. 6 when the product(s) $202_1$ ..., $202_n$ is/are run on said computer(s) $200_1$ ..., $200_n$. Said computer program products $202_1$, ..., $202_n$ can e. g. be in the form of floppy disks, RAM disks, magnetic tapes, opto magnetical disks or any other suitable products.

The invention is not limited to the embodiments described in the foregoing. It will be obvious that many different modifications are possible within the scope of the following claims.

**Claims**

1. A system (10) for digital frequency conversion, intended for use in a radio system, which system (10) comprises a frequency synthesis means (12) connected to a table look-up means (14), both operable to give an approximation of a sinusoid, **characterized in that** said system (10) also comprises a to said table look-up means (14) connected Taylor expansion means (16) operable to perform a vector rotation, thereby improving the accuracy of said sinusoid.

2. A system (10) for digital frequency conversion according to Claim 1, **characterized in that** said frequency synthesis means (12) comprises a counter means (20) with a programmable step size (S).

3. A system (10) for digital frequency conversion according to Claim 2, **characterized in that** said counter means (20) is increased with the value S for every update.

4. A system (10) for digital frequency conversion according to Claim 2 or 3, **characterized in that** said table look-up means (14) has M entries, wherein the number of bits used for the table look-up will be m = log2(M).

5. A system (10) for digital frequency conversion according to Claim 4, **characterized in that** the m most significant bits from said counter means (20) are used as an address to said table look-up means (14), i.e. the address is m_msb (counter_value), and **in that** the resolution of said counter means (20) is k bits, and **in that** k > m.

6. A system (10) for digital frequency conversion according to Claim 4 or 5, **characterized in that** the synthesized frequency is

$$f = \frac{fclk}{M} \cdot S \quad ,$$

wherein fclk is the used clock frequency.

7. A system (10) for digital frequency conversion according to any one of Claims 2 - 6, **characterized in that** said system (10) also comprises an adding means (24) connected to said counter means (20) and said table look-up means (14), wherein said adding means (24) receives an input signal from said counter means (20), and an input signal (PHOFFSET), and outputs the address to said table look-up means (14), whereby said input signal (PHOFFSET) is used to adjust the phase of said sinusoid.

8. A system (10) for digital frequency conversion according to any one of Claims 1 - 7, **characterized in that** said table look-up means (14) stores the values

$$\cos\left(2\pi \frac{n}{M}\right), \text{ and } \sin\left(2\pi \frac{n}{M}\right) \quad ,$$

wherein n=0,...,*M*-1.

9. A system (10) for digital frequency conversion according to any one of Claims 1 - 7, **characterized in that** said table look-up means (14) stores the values

$$\sin\left(2\pi\frac{n}{M}\right),$$

wherein

$$n = 0, ..., \frac{M-1}{4}.$$

**10.** A system (10) for digital frequency conversion according to any one of Claims 1 - 0, **characterized in that** said Taylor expansion means (16) comprises a number of multiplication means ($26_1$, ..., $26_t$), and a number of adding means ($28_1$, ..., $28_p$), wherein p and t are integers.

**11.** A system (10) for digital frequency conversion according to Claim 10, **characterized in that** said vector rotation can be described as:

$$\begin{bmatrix} s'_I \\ s'_Q \end{bmatrix} = \begin{bmatrix} s_I & s_Q \end{bmatrix} \cdot \begin{bmatrix} \cos(\varphi_i)\sin(\varphi_i) \\ -\sin(\varphi_i)\cos(\varphi_i) \end{bmatrix}$$

whereby $\varphi_i$ is determined by:

$$\varphi_i = \frac{2\pi \cdot m\_msb(counter\_val)}{M}$$

**12.** A system (10) for digital frequency conversion according to Claim 11, **characterized in that** said Taylor expansion means (16) performs an additional vector rotation, which can be described as:

$$\begin{bmatrix} s'_I \\ s'_Q \end{bmatrix} = \begin{bmatrix} s_I & s_Q \end{bmatrix} \cdot \begin{bmatrix} \cos(\varphi_i) & \sin(\varphi_i) \\ -\sin(\varphi_i)\cos(\varphi_i) \end{bmatrix} \cdot \begin{bmatrix} \cos(\Delta\varphi_i) & \sin(\Delta\varphi_i) \\ -\sin(\Delta\varphi_i)\cos(\Delta\varphi_i) \end{bmatrix}$$

wherein $\Delta_\varphi$ is an angle error due to the fact that not all bits in said counter means (20) are used for said table look-up.

**13.** A system (10) for digital frequency conversion according to Claim 12, **characterized in that**, assuming that $\Delta\varphi_i$ is small, the sin ( ), and cos ( ) operations can be approximated with

$$\sin(\Delta\varphi_i) \approx \Delta\varphi_i$$

$$\cos(\Delta\varphi_i) \approx 1$$

whereby said Taylor expansion means (16) performs said additional vector rotation, which can be described as:

$$\begin{bmatrix} s'_I \\ s'_Q \end{bmatrix} = \begin{bmatrix} s_I & s_Q \end{bmatrix} \begin{bmatrix} \cos(\varphi_i) & \sin(\varphi_i) \\ -\sin(\varphi_i) & \cos(\varphi_i) \end{bmatrix} \cdot \begin{bmatrix} 1 & \Delta\varphi_i \\ -\Delta\varphi_i & 1 \end{bmatrix} = S \cdot A \cdot B$$

14. A method for digital frequency conversion, intended for use in a radio system wherein said method comprises the steps:

- to perform a frequency synthesis; and
- to perform a table look-up resulting in an approximation of a sinusoid; and
- to perform a Taylor expansion in the form of a vec tor rotation, thereby improving the accuracy of said sinusoid.

15. A method for digital frequency conversion according to Claim 14, **characterized in that** said table look-up step comprises the steps:

- to generate an address for said table look-up, us ing the m most significant bits from a counter means (20), i.e. the address is m_msb (counter_value)
- to increase said counter_value with a step size S; and
- to repeat the above mentioned steps.

16. A method for digital frequency conversion according to Claim 14 or 15, **characterized in that** said table comprises M words, and **in that** the number of bits use for said table look-up will be m = log2(M).

17. A method for digital frequency conversion according to Claim 16, **characterized in that** the synthesized frequency is

$$f = \frac{fclk}{M} \cdot S \quad ,$$

wherein fclk is the used clock frequency.

18. A method for digital frequency conversion according to Claim 16 or 17, **characterized in that** said method also comprises the step:

- to add a signal (PHOFFSET) to adjust the phase of said sinusoid.

19. A method for digital frequency conversion according to any one of Claims 14 - 18, **characterized in that** said table stores the values

$$\cos\left(2\pi\frac{n}{M}\right), \text{ and } \sin\left(2\pi\frac{n}{M}\right),$$

wherein $n=0,...,M$-1.

20. A method for digital frequency conversion according to any one of Claims 14 - 18, **characterized in that** said table stores the values

$$\sin\left(2\pi\frac{n}{M}\right) \, ,$$

wherein

$$n = 0, \ldots, \frac{M-1}{4}.$$

**21.** A method for digital frequency conversion according to any one of Claims 14 - 20, **characterized in that** said vector rotation can be described as:

$$\begin{bmatrix} s'_I \\ s'_Q \end{bmatrix} = \begin{bmatrix} s_I & s_Q \end{bmatrix} \cdot \begin{bmatrix} \cos(\varphi_i) & \sin(\varphi_i) \\ -\sin(\varphi_i) & \cos(\varphi_i) \end{bmatrix}$$

whereby $\varphi_i$ is determined by:

$$\varphi_i = \frac{2\pi \cdot m\_msb(counter\_val)}{M}$$

**22.** A method for digital frequency conversion according to Claim 21, **characterized in that** said method also comprises the step:

- to perform an additional vector rotation, which can be described as:

$$\begin{bmatrix} s'_I \\ s'_Q \end{bmatrix} = \begin{bmatrix} s_I & s_Q \end{bmatrix} \cdot \begin{bmatrix} \cos(\varphi_i) & \sin(\varphi_i) \\ -\sin(\varphi_i) & \cos(\varphi_i) \end{bmatrix} \cdot \begin{bmatrix} \cos(\Delta\varphi_i) & \sin(\Delta\varphi_i) \\ -\sin(\Delta\varphi_i) & \cos(\Delta\varphi_i) \end{bmatrix}$$

wherein $\Delta\varphi$ is an angle error due to the fact that not all bits in said counter means (20) are used for said table look-up.

**23.** A method for digital frequency conversion according to Claim 22, **characterized in that,** assuming that $\Delta\varphi_i$ is small, the sin ( ), and cos ( ) operations can be approximated with

$$\sin(\Delta\varphi_i) \approx \Delta\varphi_i$$

$$\cos(\Delta\varphi_i) \approx 1,$$

whereby said additional vector rotation can be described as:

$$\begin{bmatrix} s'_I \\ s'_Q \end{bmatrix} = \begin{bmatrix} s_I & s_Q \end{bmatrix} \cdot \begin{bmatrix} \cos(\varphi_i) & \sin(\varphi_i) \\ -\sin(\varphi_i) & \cos(\varphi_i) \end{bmatrix} \cdot \begin{bmatrix} 1 & \Delta\varphi_i \\ -\Delta\varphi_i & 1 \end{bmatrix} = S \cdot A \cdot B$$

**24.** At least one computer program product ($202_1$, ..., $202_n$), intended for use in a radio system, where said at least one computer program product ($202_1$, ..., $202_n$) is/are directly loadable into the internal memory of at least one digital

computer $(200_1, ..., 200_n)$, comprising software code portions for performing the steps of Claim 14 when said at least one product $(202_1, ..., 202_n)$ is/are run on said at least one computer $(200_1, ..., 200_n)$ .

FIG 1

# FIG 2

# FIG 3

# FIG 4

S

20

24  ⊕  PHOFFSET

k-m lsb
rem

m msb

14

cos()   sin()

# FIG 5

$28_1$ half_range

$26_1$ conv_rad

I'

$28_2$

I''

$26_2$

Q'

$26_3$

$28_3$

Q''

16

# FIG 6

START — 50

Frequency synthesis — 52

Table look-up — 54

Taylor expansion — 56

END — 58

# FIG 7

START —60

Generate an address —62

Table look-up —64

First vector rotation —66

Second vector rotation —68

74

Increase counter-value with S

Is the counter-value enough? —70

No

Yes

END —72

EP 1 646 142 A1

## FIG 8

$200_1$

$202_1$

$200_n$

$202_n$

22

**European Patent Office**

## EUROPEAN SEARCH REPORT

Application Number

EP 04 02 3958

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 0 801 465 A (CONTINENTAL ELECTRONICS CORPORATION) 15 October 1997 (1997-10-15) | 1,8-14, 16,19-24 | H03C3/40 |
| Y | * abstract * <br><br> * page 7, line 22 - page 9, line 20 * <br> * figure 1 * <br> ----- | 2-7,15, 17,18 | |
| X | US 2001/006543 A1 (KOIZUMI SHINJI ET AL) 5 July 2001 (2001-07-05) | 1,8-14, 16,19-24 | |
| A | * paragraph [0023] - paragraph [0038]; figures 1,3 * <br> ----- | 2-7,15, 17,18 | |
| Y | TIERNEY J ET AL: "A digital frequency synthesizer" IEEE TRANSACTIONS ON AUDIO AND ELECTROACOUSTICS, vol. Au-19, no. 1, March 1971 (1971-03), pages 48-57, XP002321597 USA ISSN: 0018-9278 | 2-7,15, 17,18 | |
| A | * page 49, right-hand column, line 1 - page 50, left-hand column, line 8 * <br> * page 50, right-hand column, line 29 - page 51, left-hand column, line 4 * <br> * figures 4,7 * <br> ----- | 1,14,24 | **TECHNICAL FIELDS SEARCHED (Int.Cl.7)** <br><br> H04L |

The present search report has been drawn up for all claims

| Place of search | Date of completion of the search | Examiner |
|---|---|---|
| The Hague | 17 March 2005 | Marselli, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 04 02 3958

This annex lists the patent family members relating to the patent documents cited in the above-mentioned European search report.
The members are as contained in the European Patent Office EDP file on
The European Patent Office is in no way liable for these particulars which are merely given for the purpose of information.

17-03-2005

| Patent document cited in search report | | Publication date | Patent family member(s) | | Publication date |
|---|---|---|---|---|---|
| EP 0801465 | A | 15-10-1997 | US | 6032028 A | 29-02-2000 |
| | | | CA | 2202317 A1 | 12-10-1997 |
| | | | CN | 1168572 A | 24-12-1997 |
| | | | DE | 69702325 D1 | 27-07-2000 |
| | | | EP | 0801465 A1 | 15-10-1997 |
| | | | ES | 2147422 T3 | 01-09-2000 |
| US 2001006543 | A1 | 05-07-2001 | JP | 3552622 B2 | 11-08-2004 |
| | | | JP | 2001184888 A | 06-07-2001 |
| | | | CN | 1307404 A | 08-08-2001 |

EPO FORM P0459

For more details about this annex : see Official Journal of the European Patent Office, No. 12/82